(19) Europäisches Patentamt
European Patent Office
Office européen des brevets

(11) EP 1 343 250 B1

(12) **FASCICULE DE BREVET EUROPEEN**

(45) Date de publication et mention de la délivrance du brevet:
**06.05.2009 Bulletin 2009/19**

(51) Int Cl.:
***H03H 7/06*** *(2006.01)* ***H03H 9/54*** *(2006.01)*

(21) Numéro de dépôt: **03100531.7**

(22) Date de dépôt: **04.03.2003**

(54) **Filtre intégrateur à temps continu et à variation de phase minimale, modulateur Sigma-Delta passe bande utilisant un tel filtre**

Zeitkontinuierliche Integrator-Minimumphasenfilterschaltung, Bandpass-Sigma-Delta-Modulator mit einem solchem Filter

Continuous time integrator filter with minimum phase variation, passband Sigma-Delta modulator using this filter

(84) Etats contractants désignés:
**AT BE BG CH CY CZ DE DK EE ES FI FR GB GR HU IE IT LI LU MC NL PT RO SE SI SK TR**

(30) Priorité: **08.03.2002 FR 0202957**

(43) Date de publication de la demande:
**10.09.2003 Bulletin 2003/37**

(73) Titulaire: **Thales**
**75008 Paris (FR)**

(72) Inventeurs:
- **HODE, Jean-Michel**
  **94117 CX, ARCUEIL (FR)**
- **FLOUZAT, Christophe**
  **94117 CX, ARCUEIL (FR)**
- **DE GOUY, Jean-Luc**
  **94117 CX, ARCUEIL (FR)**

(74) Mandataire: **Lucas, Laurent Jacques et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**DE-A- 2 757 460**
**DE-A- 3 504 383**
**US-A- 4 467 291**
**US-A- 5 136 651**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

Printed by Jouve, 75001 PARIS (FR)

EP 1 343 250 B1

## Description

L'invention concerne le filtrage en temps continu. Et, plus particulièrement, elle concerne un modulateur sigma delta ΣΔ. Les modulateurs ΣΔ analogiques peuvent être utilisés, par exemple, dans les récepteurs de radars ou de systèmes de télécommunications pour améliorer notablement la résolution du codage analogique-numérique.

La modulation ΣΔ d'un signal consiste à le coder sur un faible nombre de bits mais avec une résolution bien plus forte que la limite théorique donnée par le nombre de bits. Pour cela, une boucle d'asservissement est réalisée dans laquelle le dispositif de quantification, qui limite la résolution, est placé en sortie de boucle comme le montre le schéma générique de la figure 1(a).

Si le signal est numérique, l'ensemble du modulateur ΣΔ est réalisé en numérique. Lorsque le signal numérique à l'entrée du modulateur ΣΔ comporte N bits, le signal de retour comporte N bits dont N-n bits de poids faibles (LSB) nuls, le signal à l'entrée du dispositif d'intégration 1 comporte N+1 bits, et le signal à l'entrée et à la sortie du dispositif de quantification 2 comporte respectivement N bits et n bits (où n est très inférieur à N). Ainsi, le signal codé en sortie du modulateur ΣΔ est à faible nombre de bits et à forte résolution dans la bande. C'est typiquement le cas dans les lecteurs de CD où la sortie du modulateur s'effectue sur 1 bit alors que le signal d'entrée est codé sur une vingtaine de bits.

Par contre, si le signal est analogique, la numérisation 2 - génératrice de la quantification qui limite la résolution étant placée en sortie de boucle comme le montre la figure 1(b), il en résulte que le filtrage 11, qui réalise l'intégration de l'erreur entrée/sortie, est nécessairement analogique. Deux cas se présentent. Soit la fréquence du signal est suffisamment basse et le signal peut être échantillonné en tête de boucle - non représenté - avant le filtrage 11 qui s'effectue alors dans le domaine temporel discret (capacités commutées par exemple). A plus haute fréquence, en particulier sur porteuse, les techniques en temps discret (capacités ou boucles de courant commutés, notamment) s'appliquent mal. Le filtrage 11 peut alors réaliser en temps continu dont la technologie la plus courante est le GmC (utilisation d'amplificateurs à transconductance). L'échantillonnage s'effectue alors en sortie de boucle juste avant la quantification (conversion analogique-numérique).

Par ailleurs, toujours en haute fréquence, les temps de conversions cumulés des convertisseurs analogique-numérique 2 CAN et numérique-analogique 3 CNA s'étalent sur plusieurs périodes d'échantillonnage au lieu d'être inférieurs à une seule période. Ce problème disparaît si le codage s'effectue sur un seul bit, mais alors la très forte non-linéarité de la fonction codage ne permet pas de définir à coup sûr un critère de stabilité du modulateur ΣΔ. Un codage multibit est alors préféré, pour lequel la réponse de la boucle ouverte peut être considérée comme linéaire au premier ordre.

La réalisation du filtre 11 de boucle doit alors résoudre la problématique classique des boucles d'asservissement : apporter le maximum de gain (ce qui minimise l'erreur entre le signal asservi et la commande) tout en préservant la stabilité de la boucle, ce qui est d'autant plus difficile à réaliser que le temps de retard total de la boucle, encore appelé nombre de latence, est important. C'est la difficulté de trouver des fonctions de filtrage performantes même en présence de nombreuses latences qui a, jusqu'à aujourd'hui, limité le développement des modulateurs ΣΔ en temps continu.

La demande de brevet DE 35 04 383 décrit un filtre à minimum de phase à fonction de transfert passe-bas, passe-haut, passe-bande ou coupe-bande. La fonction de transfert comporte également une bande atténuée réalisée au moyen d'éléments piézoélectriques.

La demande de brevet US 4 467 291 décrit un modulateur sigma delta dont le filtre est un réseau à déphasage minimal.

La présente invention permet de résoudre les difficultés du filtrage en temps continu de façon quasi-optimale en minimisant la phase du filtre sur le domaine fréquentiel où le gain de la boucle est proche de 1 en module.

Notamment, elle propose un modulateur sigma delta tel que décrit par les revendications.

Des éléments à variation de phase minimale sont des éléments dont la phase dépliée, c'est à dire reconstituée par continuité aux points d'ambiguïté, tend vers zéro lorsque la fréquence tend vers zéro ou l'infini.

La réalisation de filtre en temps continu comme intégrateur passe bande pose le problème du compromis entre variations de gain et variations de phase au voisinage des points -1, compromis qui doit aboutir à la stabilité de la boucle. Du fait de la causalité ces variations sont liées par les relations de Bayard-Bode. Ce problème est résolu en utilisant un filtre temps continu intégrateur passe bande comportant au moins un dispositif de résonance à variation de phase minimale. Notamment, ledit dispositif de résonance à variation de phase minimale comporte un résonateur et une résistance.

Les caractéristiques et avantages de l'invention apparaîtront plus clairement à la lecture de la description, faite à titre d'exemple, et des figures s'y rapportant qui représentent :

- Figure 1(a) et 1(b), des schémas génériques de modulateur ΣΔ passe bande temps continu, respectivement pour le traitement d'un signal quelconque et d'un signal analogique,
- Figure 2(a) et 2(b), des filtres temps continu intégrateur passe bande d'ordre 1 selon l'état de l'art,

- Figure 3(a) et 3(b), les réponses fréquentielles respectivement en phase et en amplitude des filtres des figures 2,
- Figure 4(a) et 4(b), une première et une deuxième variantes de filtres temps continu intégrateur passe bande d'ordre 1 selon l'invention,
- Figure 5(a) et 5(b), les réponses fréquentielles respectivement en phase et en amplitude des filtres des figures 4, en fonction de la surtension du résonateur $Q_d$,
- Figure 6(a) et 6(b), une troisième et une quatrième variantes de filtres temps continu intégrateur passe bande d'ordre 1 selon l'invention,
- Figure 7(a) et 7(b), les réponses fréquentielles respectivement en phase et en amplitude des filtres des figures 6, en fonction de la surtension du résonateur $Q_d$,
- Figure 8, un cinquième variante de filtre temps continu intégrateur passe bande d'ordre supérieur selon l'invention,
- Figure 9, un circuit équivalent au résonateur selon l'état de l'art,
- Figure 10(a) et 10(b), deux exemples de dispositif de résonance équivalent selon l'invention,
- Figure 11, une sixième variante de filtre temps continu intégrateur passe bande d'ordre supérieur utilisant le dispositif de résonance équivalent des figures 10 avec une structure en échelle,
- Figure 12, une septième variante de filtre temps continu intégrateur passe bande d'ordre supérieur en mode différentiel utilisant le dispositif de résonance équivalent des figures 10 avec une structure en échelle,
- Figure 13(a) et 13(b), les réponses fréquentielles respectivement en phase et en amplitude du filtre de la figure 12,
- Figure 14, un modulateur ΣΔ passe bande temps continu utilisant le filtre temps continu intégrateur passe bande d'ordre supérieur de la figure 11,
- Figure 15, une huitième variante de filtre temps continu intégrateur passe bande d'ordre supérieur utilisant le dispositif de résonance équivalent des figures 10 avec une structure pont,
- Figure 16(a) et 16(b), les réponses fréquentielles respectivement en phase et en amplitude du filtre de la figure 15.

Un modulateur ΣΔ passe-bande permet de coder un signal en numérique avec une résolution dans la bande utile bien meilleure que celle d'un codeur classique. Sa fonction réelle, outre la numérisation, est de conformer le bruit de quantification de sorte que, dans la bande utile, la densité spectrale de ce bruit soit bien inférieure à celle issue d'un codeur classique. Cette réduction de la densité spectrale de puissance du bruit de quantification dans la bande utile se traduit par un gain équivalent en résolution après filtrage du bruit hors bande et décimation.

La figure 1 montre un exemple schématique de modulateur ΣΔ passe bande en temps continu. Le modulateur ΣΔ passe bande en temps continu est une boucle d'asservissement. Sur la voie directe v1 de la boucle, il comporte le dispositif d'intégration 1 suivi d'un convertisseur analogique numérique 2 (CAN). Le dispositif d'intégration 1 comporte un dispositif de filtrage 11 permettant l'intégration et un amplificateur 12 de l'erreur dans la bande utile. Sur la voie retour v2, il comporte un convertisseur numérique analogique 3 (CNA). Ce convertisseur (CNA) 3 permet de ramener le signal converti obtenu en sortie du modulateur ΣΔ à l'entrée de celui-ci. Un opérateur 4 est placé à l'entrée de la boucle avant le dispositif d'intégration 1. Il reçoit le signal à coder présent sur l'entrée du modulateur ΣΔ provenant, par exemple, des étages d'entrée d'un récepteur dans le cas de l'utilisation du modulateur ΣΔ dans un système de radar ou de télécommunications. Il reçoit en outre le signal converti provenant de la voie retour après la conversion numérique analogique. Cet opérateur 4 permet d'évaluer la différence entre le signal d'entrée et le signal converti, de sorte que le dispositif d'intégration passe-bande intègre, dans la bande, l'erreur entre le signal de sortie et le signal d'entrée.

Le gain de la boucle ouverte est très supérieur à 1 dans la bande utile si bien que, dans cette bande utile, l'erreur entre le signal de sortie et le signal d'entrée est nécessairement très faible ; c'est le principe d'une boucle d'asservissement. Ceci entraîne que le bruit de quantification en sortie de boucle se trouve rejeté d'un facteur équivalent à ce gain. Ce bruit de quantification sur le signal de sortie résulte de la conversion analogique numérique.

Le gain de la boucle doit donc être le plus élevé possible. Cependant, compte tenu des temps nécessaires pour effectuer les deux conversions 2 et 3, le choix d'un gain aussi grand que désiré n'est pas possible. En effet, dans la pratique, la boucle doit respecter le critère de Nyquist. Donc, pour des convertisseurs 2 et 3 donnés, la stabilité de la boucle est donc entièrement déterminée par le filtrage 11 et le gain 12 de l'opération d'intégration 1.

Pour minimiser le retard lié au filtrage et, en conséquence, préserver la stabilité de la boucle, le filtre passe-bande 11 doit être multi-pôle lorsqu'il est réalisé en temps continu. Ce type de filtre temps continu peut être représenté, au niveau du principe, comme une cascade de résonateurs d'ordre 1 encadrés chacun d'amplificateurs parfaits et formant chacun un filtre d'ordre 1. La fonction de transfert de l'ensemble est la somme (en amplitude logarithmique et phase) des réponses individuelles. Celles-ci s'obtiennent en plaçant ces résonateurs, en série ou en parallèle, entre un générateur 52 d'impédance interne 51 et une charge 7. Les résonateurs LC tels que représentées sur les figures 2(a) et 2(b) sont envisagés habituellement.

La figure 2(a) illustre un résonateur série. Il comporte un circuit LC série $6_s$, en série avec une inductance L 61 et capacité C 62. La figure 2(b) illustre un résonateur parallèle. Il comporte un circuit LC parallèle $6_p$, en parallèle avec une inductance L 61 et capacité C 62.

Mais de tels filtres 11 temps continu avec de simple résonateur LC 6 ne présentent pas une phase avec des

variations minimales. Dans la pratique, le retour à zéro de la phase loin de la fréquence de résonance ou d'anti-résonance est importante. En effet, si cela n'est pas vérifié, il y a instabilité de la boucle dans laquelle un tel filtre est placé.

La figure 3(a) montre la réponse en phase des dispositifs de résonance des figures 2 en fonction de la fréquence. L'axe des fréquences est normalisé par rapport à la fréquence de résonance. La phase présentée par la figure 3(a) tend vers 90° quand la fréquence tend vers 0 ou -90° quand la fréquence tend vers l'infini. Or, pour avoir une variation de phase minimale, la phase doit tendre vers zéro lorsque la fréquence tend vers zéro ou l'infini. Donc, d'après la figure 3(a), les filtres avec de simple résonateur LC tels que proposés sur les figures 2 ne sont pas à variation de phase "dite" minimale.

La figure 3(b) représente la réponse en amplitude des dispositifs de résonance des figures 2 en fonction de la fréquence. L'axe des fréquences est normalisé par rapport à la fréquence de résonance. L'amplitude ne sature pas loin de la fréquence de résonance. La forme de la réponse en amplitude explique, par relation de causalité, le type de variation en phase observée sur la figure 2(a).

Afin d'avoir une bonne stabilité, tout en ayant un gain satisfaisant, le filtre utilisé 11 doit être un filtre intégrateur passe bande en temps continu avec variation de phase minimale. Plus précisément, il a une fonction de transfert de la forme :

$$H(p) \propto \frac{p^2 + \dfrac{\omega_0}{Q_N} p + \omega_0^2}{p^2 + \dfrac{\omega_0}{Q_D} p + \omega_0^2}$$

Suivant les valeurs de $Q_N$ et de $Q_D$ la fonction réalisée diffère. En effet, si $Q_D \geq Q_N$ la fonction réalisée est un filtrage de bande avec retard de phase car la phase décroît avec la fréquence autour de la fréquence de résonance. Si $Q_D \leq Q_N$, le filtre réalisé est un réjecteur de bande avec avance de phase. $Q_D$ représente le maximum de la fonction de transfert en amplitude du résonateur 6 (ou dispositif de résonance). Le rapport $Q_D/Q_N$ représente le rapport entre le maximum et le minimum de la fonction de transfert en amplitude du résonateur 6 (ou dispositif de résonance).

La présente invention consiste à réaliser ceci en proposant des dispositifs de résonance $6'_{s1}$, $6'_{s2}$, $6'_{p1}$, $6'_{p2}$, $6''_s$ et $6''_p$ en lieu et place des résonateurs 6.

Les première, deuxième, troisième et quatrième variantes de l'invention sont illustrées par les figures 4(a), 4 (b), 6(a) et 6(b). Elles proposent pour réaliser un dispositif de résonance $6'_{s1}$, $6'_{s2}$, $6'_{p1}$ ou $6'_{p2}$ d'ajouter au circuit LC 6 une résistance soit en série, soit en parallèle.

Dans la première variante du filtre selon l'invention de la figure 4(a), une résistance 63 est placée en parallèle sur un résonateur série 61-62. Ainsi, à la résonance, le résonateur 61-62 est prépondérant dans le fonctionnement du dispositif de résonance $6'_{s1}$. Et, loin de la résonance, lorsque l'impédance du résonateur 61-62 est grande, la résistance 63 devient prépondérante. Cela est illustré par les figures 5(a) et 5(b).

La figure 5(a) représente différentes réponses en phase de cette variante du filtre 11 en fonction de la fréquence pour une valeur $Q_N$ = 7. Les réponses représentées par les courbes c1, c2 et c3 correspondent à celles d'un filtre 11 dont la valeur respective de $Q_D$ = 10, 20 et 14. L'axe des fréquences est normalisé par rapport à la fréquence de résonance. Le dispositif de résonance $6'_{s1}$ est un élément à variation de phase minimale comme l'indique la figure 5 (a). En effet, la phase tend vers 0 quand la fréquence tend vers 0 ou l'infini.

La figure 5(b) représente différentes réponses en amplitude de cette variante du filtre 11 en fonction de la fréquence pour une valeur $Q_N$ = 7. Les réponses représentées par les courbes c1, c2 et c3 correspondent à celles d'un filtre 11 dont la valeur respective de $Q_D$ = 10, 20 et 14. L'axe des fréquences est normalisé par rapport à la fréquence de résonance.

De façon duale une résistance 63 peut être placée en série avec un résonateur de type parallèle 61-62 pour composer un dispositif de résonance $6'_{p1}$ comme illustré par la figure 4(b).

La fonction de transfert de ce type de dispositif de résonance $6'_1$ a la forme générale suivante:

$$H(p)=\frac{1+Q_N\left(\frac{p}{\omega_0}+\frac{\omega_0}{p}\right)}{1+Q_D\left(\frac{p}{\omega_0}+\frac{\omega_0}{p}\right)}=\frac{Q_N}{Q_D}\frac{p^2+\frac{\omega_0}{Q_N}p+\omega_0^2}{p^2+\frac{\omega_0}{Q_D}p+\omega_0^2}$$

avec $\begin{cases} Z=\sqrt{\frac{L}{C}} \\ LC\omega_0^2=1 \end{cases}$ et : $\begin{cases} Q_N=\frac{Z}{R} \\ Q_D=\left(\frac{1}{R}+\frac{1}{2R_0}\right)Z \end{cases}$

pour les dispositifs de résonance série $6'_{s1}$ ,et $\begin{cases} Q_N=\frac{R}{Z} \\ Q_D=\frac{1}{Z}\left(R+\frac{R_0}{2}\right) \end{cases}$ pour les dispositifs de résonance série $6'_{p1.}$

En modifiant et plaçant différemment les éléments de ces dispositifs de résonance 6' comme indiqué sur les figures 6(a) et 6(b), les filtres réalisés ont une fonction de réjection de bande avec avance de phase. Dans la troisième variante du filtre 11 selon l'invention de la figure 6(a), une résistance 63 est placée en série sur un résonateur LC 61-62 série placé en parallèle. Ainsi, à la résonance, la résistance 63 devient prépondérante dans le fonctionnement dispositif de résonance $6'_{s2}$. Et, loin de la résonance, l'impédance du résonateur 61-62 devient grande devant la résistance 63. Cela est illustré par les réponses fréquentielles de cette variante filtre 11 en phase de la figure 7(a) et en amplitude de la figure 7(b).

La figure 7(a) représente différentes réponses en phase de cette variante du filtre 11 comportant un dispositif de résonance $6'_{s2}$ en fonction de la fréquence pour une valeur $Q_N = 7$. Les réponses représentées par les courbes c4, c5 et c6 correspondent à celles d'un filtre 11 dont la valeur respective de $Q_D = 2.5$, 3.5 et 5. L'axe des fréquences est normalisé par rapport à la fréquence de résonance. Le dispositif de résonance $6'_{s2}$ est un élément à variation de phase minimale comme l'indique la figure 7(a). En effet, la phase tend vers 0 quand la fréquence tend vers 0 ou l'infini.

La figuré 7(b) représente différentes réponses en amplitude de cette variante du filtre 11 comportant un dispositif de résonance $6'_{s2}$ en fonction de la fréquence pour une valeur $Q_N = 7$. Les réponses représentées par les courbes c4, c5 et c6 correspondent à celles d'un filtre 11 dont la valeur respective de $Q_D = 2.5$, 3.5 et 5. L'axe des fréquences est normalisé par rapport à la fréquence de résonance

Donc, suivant le type de dispositif de résonance désiré (par exemple à retard de phase, avance de phase...), la structure de ce dispositif de résonance est réalisée telle que la fonction de la résistance 63 devient prépondérante sur celle du résonateur dans une ou plusieurs bandes de fréquence déterminée (respectivement, bandes de fréquences excluant la fréquence de résonance, bande de fréquence incluant la fréquence de résonance...).

De façon duale une résistance 63 peut être placée en parallèle avec un résonateur LC 61-62 de type parallèle placé en série dispositif de résonance $6'_{p2}$ comme indiqué en figure 6(b).

La fonction de transfert de ce type de dispositif de résonance $6'_2$ a la forme générale suivante:

$$H(p)=\frac{\frac{1}{Q_N}+\left(\frac{p}{\omega_0}+\frac{\omega_0}{p}\right)}{\frac{1}{Q_D}+\left(\frac{p}{\omega_0}+\frac{\omega_0}{p}\right)}=\frac{p^2+\frac{\omega_0}{Q_N}p+\omega_0^2}{p^2+\frac{\omega_0}{Q_D}p+\omega_0^2}\ \text{avec}\ \begin{cases} Z=\sqrt{\frac{L}{C}} \\ LC\omega_0^2=1 \end{cases}\ \text{et :}$$

et : $\begin{cases} \frac{1}{Q_N} = \frac{R}{Z} \\ \frac{1}{Q_D} = \frac{1}{Z}\left(R + \frac{R_0}{2}\right) \end{cases}$ pour les dispositifs de résonance série $6'_{s2}$ et $\begin{cases} \frac{1}{Q_N} = \frac{Z}{R} \\ \frac{1}{Q_D} = \left(\frac{1}{R} + \frac{1}{2R_0}\right)Z \end{cases}$ pour les dispositifs de résonance série $6'_{p2}$.

Un filtre 11 d'ordre supérieur est constitué de plusieurs éléments de base que sont les dispositifs de résonance. Donc, la réalisation d'un filtre 11 selon l'invention d'ordre supérieur peut comporter une cascade de plusieurs d'une ou plusieurs des premières à quatrièmes variantes de dispositifs de résonance $6'_{s1}$, $6'_{s2}$, $6'_{p1}$, $6'_{p2}$ proposés ci-dessus. Cette cascade pour obtenir le filtre d'ordre supérieur peut être réalisé soit à travers des amplificateurs qui permettent une multiplication des fonctions de transfert, soit par assemblage direct pour réaliser des filtres en échelle comme l'illustre la figure 8, soit par assemblage en structure de pont équilibré comme l'illustre la figure 12.

Sur la figure 8, seuls sont représentés des dispositifs de résonance $6'_{s1}$, $6'_{p1}$ comportant des éléments de filtrage mais il est entendu que les combinaisons qui suivent peuvent s'étendre sans difficulté, en toute généralité, aux éléments d'avance de phase $6'_{s2}$, $6'_{p2}$, y compris de façon mixte. Le filtre 11 de la figure 8 est une cascade en échelle alternative de dispositifs de résonance $6'_{s1}$, $6'_{p1}$. Chaque couple de dispositifs de résonance $6'_{s1}$, $6'_{p1}$ forme une section. Le filtre 11 est constituée de N sections.

Dans la pratique, il peut être difficile de disposer d'inductances présentant de très bons facteurs de qualité ce qui empêche de réaliser ainsi (avec des inductances et des capacités) des résonateurs présentant de grandes surtensions. Or la surtension des résonateurs est un facteur fondamental pour la stabilité de boucle d'un modulateur ΣΔ surtout dans le cas de temps de conversions importants, car plus grande est cette surtension et plus faible est la phase dans la zone critique. C'est la raison de l'utilisation des technologies de résonateurs monolithiques ou intégrées, présentant de très bonnes surtensions, telles que, de façon non limitative, les résonateurs à ondes acoustiques de volume (BAW) et leurs variantes TFR (Thin Film Resonators en anglais, c'est à dire résonateur à film mince) ou FBAR (Fundamental Bulk Acoustic Resonator en anglais, c'est à dire résonateur acoustique en volume sur fondamental) ou HBAR (High order Bulk Acoustic Resonator en anglais, c'est à dire résonateur acoustique en volume d'ordre de résonance supérieur), les résonateurs à ondes acoustiques de surface (SAW), les résonateurs diélectriques, les résonateurs réalisés en microtechnologies (MEMS) ... Cependant bien souvent ces résonateurs ne sont pas de simples circuits LC 61-62, série ou parallèle, mais présentent plutôt un schéma équivalent illustré par la figure 9 composé d'une branche résonante série avec les composants LC 61-62 et d'une capacité statique parallèle 64. Ainsi, ils présentent à la fois une résonance et une anti-résonance.

Les dispositifs de résonance $6''_s$, $6''_p$ peuvent ainsi être modifiés comme illustrés par la figure 10(a) pour un résonateur LC 61-62 série dont le fonctionnement sera de type série en filtrage ou de type parallèle en avance de phase, et la figure 10(b) pour un résonateur LC 61-62 dont le fonctionnement sera de type parallèle en filtrage ou de type série en avance de phase. Ces dispositifs de résonances $6''_s$, $6''_p$ sont utilisé dans le filtre 11 soit d'ordre 1, soit d'ordre supérieur comme décrit plus haut, en cascade via des amplificateurs ou en couplage direct en échelle comme illustrée par l'exemple de la figure 11. Dans cette figure 11, tous les dispositifs de résonance $6''_s$, $6''_p$ peuvent être différents pour optimiser les performances de l'ensemble. Il est également à noter que, dans cette figure, il n'y a plus de différence de structure entre filtrage à retard et avance de phase, cette différence s'opérant par les ratio des résistances aux impédances des résonateurs, la bande de fréquence considérée et le placement du couple résistance - résonateur dans le filtre.

La figure 11 apparaît donc comme une figure générique et générale dans laquelle l'une ou l'autre de la capacité statique 64 d'un dispositif de résonance $6''_s$, $6''_p$ ou de sa capacité série 62 peut être nulle. Dans le cas où ceci se produirait pour tout les dispositif de résonance $6''_s$, $6''_p$, on retrouve la plus générale des structures à inductances et capacités, décrite de façon particulière par la figure 8.

Bien entendu la structure générique de la figure 11 peut, de façon évidente, se symétriser pour un fonctionnement en différentiel comme illustré par la figure 12 dans laquelle les dispositifs de résonance $6''_p$ ont l'impédance double des dispositifs de résonance $6''_p$ de la figure 11. De plus, l'impédance 51 du dispositif source $5_S$ et l'impédance 7 du filtre de la figure 12 sont, elles aussi, double par comparaison avec celle du filtre de la figure 11.

Une réponse fréquentielle typique obtenue à l'aide de ce type de structure de filtre est présentée en phase par la figure 13(a) et en amplitude par la figure 13(b). Il s'agit de la réponse linéaire approchant la réponse en boucle ouverte d'un modulateur ΣΔ de fréquence centrale $f_0 = {}^{3f_s}\!/_{8}$ où $f_s$ est la fréquence d'échantillonnage. Un exemple de structure d'un tel modulateur ΣΔ est donnée par la figure 14. Dans lequel ce modulateur ΣΔ, la paire formée par le convertisseur analogique numérique 2 et le convertisseur numérique analogique 3 a un temps de traitement global cumulé de 4.82 temps d'échantillonnage. Cette réponse tient compte du repliement de spectre apporté par le convertisseur analogique numérique 2 et du filtrage en sinus cardinal apporté par le convertisseur numérique analogique 3.

Dans l'exemple proposé par la figure 14, le filtrage de boucle 11 comporte deux filtres 11(2) et 11(3). Chacun de ces filtres 11 peut être découpé en trois sections. Le filtrage de boucle 11 comporte en outre deux cellules résonantes $6_p(1)$ et $6_p(4)$ encadrant un circuit série alternant un premier amplificateur 12(1), le premier filtre 11(2), un deuxième amplificateur 12(2), le deuxième filtre 11(3) et un troisième amplificateur 12(3).

Chacune des trois sections des filtres 11(2) et 11(3) comporte elle-même deux dispositifs de résonance, l'un série $6''_s$ et l'autre parallèle $6''_p$, tel qu'illustré sur la figure 11. Les cellules résonantes $6_p(1)$ et $6_p(4)$ sont à faible surtension car destinées à minimiser les effets sur la réponse du repliement de spectre apporté par le convertisseur analogique numérique 2. Le fonctionnement du modulateur en boucle fermée est alors stable avec les marges suivantes: ± 20 degrés en phase et ± 3 dB en amplitude.

Le tableau suivant rassemble des exemples de valeurs des éléments des différentes sections des filtres 11 (2) et 11(3):

| | Dispositif de résonance | $\frac{\omega_r - \omega_0}{\omega_0}$ | $Z/R_0$ | $R/R_0$ |
|---|---|---|---|---|
| Section n°1 | Série $6''_s(1)$ | $0,408 \cdot 10^{-2}$ | 1.46 | 0,94 |
| | Parallèle $6''_p(1)$ | $-3,395 \cdot 10^{-2}$ | 0,72 | 0,78 |
| Section n°2 | Série $6''_s(2)$ | $0,480 \cdot 10^{-2}$ | 1,85 | 1,54 |
| | Parallèle $6''_p(2)$ | $-4,113 \cdot 10^{-2}$ | 0,52 | 0,58 |
| Section n°3 | Série $6''_s(3)$ | $0,421 \cdot 10^{-2}$ | 1,87 | 1,67 |
| | Parallèle $6''_p(3)$ | $-3,690.10^{-2}$ | 0,50 | 0,59 |

Une autre structure peut être proposée dans le cas spécifique d'un fonctionnement en mode différentiel. Cette structure, dont le principe est donné par la figure 15, est une structure en pont équilibré. Le pont équilibré comporte les capacités statiques 64 des dispositifs de résonance $6''_s(a)$ et $6''_s(b)$ et des capacités additionnelles $62_1$ et $62_3$ de même valeur. Par la présence des deux résistances 63(a) et 63 (b) et des deux branches résonantes 61-62 (a) et 61-62 (b) des dispositifs de résonance $6''_s(a)$ et $6''_s(b)$, il y a déséquilibre du pont. Cela permet d'une part d'obtenir la réponse dans la bande et d'autre part de limiter la réponse sous la forme d'un pseudo-plateau en réjection proche dans le but de limiter les variations de la phase.

Dans la bande passante, c'est à dire autour de la résonance des dispositifs de résonance $6''_s(a)$ et $6''_s(b)$, la compensation de l'impédance des capacités statiques additionnelles $62_1$ et $62_3$ peut être réalisée par deux inductances $61_1$ et $61_3$. Le fonctionnement est alors optimal pour $LC\omega_r^2 = 1$.

Ces structures en pont peuvent être cascadées, en général avec des fréquences centrales différentes, pour obtenir un filtrage d'ordre supérieur.

Les figures 16(a) et 16(b) donne un exemple de réponse fréquentielle, respectivement en phase et en amplitude, en boucle ouverte d'un modulateur ΣΔ de fréquence centrale $f_0 = 3f_s/4$ et comportant une paire de convertisseur analogique numérique 2 et numérique analogique 3 à temps de traitement global cumulé de 7,5 périodes d'échantillonnage, un filtre 11 obtenu par cascade de quatre structures de type pont illustré par la figure 15. Les fréquences et impédances des résonateurs vérifient $\frac{\omega_a^2}{\omega_r^2} - 1 = \frac{1}{150}$,, $RC\omega_r = 0,943$ et

$$\frac{\omega_r - \omega_0}{\omega_0} = \pm 2,53 \cdot 10^{-3} \text{ et } \pm 2,94 \cdot 10^{-3}.$$

A la lecture des réponses présentées sur ces figures 16(a) et 16(b), le fonctionnement du modulateur en boucle fermée est stable avec les marges suivantes : ± 20 degrés en phase et ± 3 dB en amplitude.

Les convertisseurs du modulateur ΣΔ peuvent, de manière générale, être choisi pour présenter des retards supérieurs à un temps d'échantillonnage. Dans un exemple de réalisation du modulateur ΣΔ, soit un, soit certains, soit tous les éléments du modulateur ΣΔ sont intégrés sur un semi-conducteur.

Les résistances 63 peuvent être soit réalisées sur un substrat piézo-électrique, soit réalisées ou reportées à

l'intérieur d'un boîtier céramique. Les capacités 62 peuvent être réalisées ou reportées à l'intérieur d'un boîtier céramique. Un ou plusieurs résonateurs 61-62 peuvent être, soit un résonateur céramique, soit un résonateur à ondes acoustiques de surface (SAW), soit un résonateur à ondes acoustiques de volume (BAW), ou ses variantes FBAR (Fundamental Bulk Acoustic Resonator) soit HBAR (High order Bulk Acoustic Resonator), ou TFR (Thin Film Resonator), soit un résonateur diélectrique, soit un résonateur réalisé en supraconducteur, soit un résonateur de type GmC [Capacité + amplificateur à transconductance]. De plus, le substrat piézo-électrique des résonateurs acoustiques (SAW, BAW, TFR, FBAR, HBAR) peut être intégré sur silicium.

La réalisation des éléments du filtre (résistance, condensateur, inductance) sur substrat piézo-électrique permet de résoudre les problèmes d'interconnections entre les éléments et de simplifier la réalisation du filtre . L'un des avantages de la réalisation des éléments du filtre (résistance, condensateur, inductance) sur substrat piézo-électrique ou à l'intérieur d'un boîtier céramique est une meilleure maîtrise de la fonction de transfert du filtre. En outre, le filtre réalisé sur substrat piézo-électrique peut être rapporté sur le semi-conducteur comportant un ou plusieurs des éléments du modulateur ΣΔ.

Les exemples données d'application ont été illustrés par le modulateur ΣΔ, ils peuvent être généralisés à l'application dans tout type de boucle d'asservissement. Grâce à l'invention, une boucle d'asservissement comportant un nombre de latence supérieur stricte à 1 peut être réalisé sans risque d'instabilité de cette boucle.

## Revendications

1. Modulateur sigma delta (ΣΔ) passe-bande formant une boucle d'asservissement comportant un filtre réalisant l'intégration passe-bande d'un signal présenté sur son entrée, cette opération étant effectuée en temps continu, **caractérisé en ce que** ledit filtre comporte un dispositif de résonnance ($6'_{s1}$, $6'_{s2}$, $6'_{p1}$, $6'_{p2}$, $6''_s$ et $6''_p$) à variation de phase minimale, ledit dispositif de résonnance comportant un résonateur (61-62, 64) et une résistance (63) dont la fonction devient prépondérante sur celle du résonateur ($6_s$, $6_p$ et/ou 64) dans une ou plusieurs bandes de fréquence déterminées.

2. Modulateur selon la revendication 1, **caractérisé en ce que** le dispositif de résonance ($6'_{s1}$, $6'_{p1}$) à variation de phase minimale est à retard de phase lorsque la fonction de la résistance est prépondérante dans des bandes de fréquence symétriques par rapport à la fréquence de résonance et excluant la fréquence de résonance.

3. Modulateur selon la revendication 2**, caractérisé en ce que** le dispositif de résonance ($6'_{s1}$, $6'_{p1}$) à variation de phase minimale et à retard de phase comporte :

   - soit un résonateur série ($6_s$) en parallèle avec la résistance (63), ledit résonateur série ($6_s$) comportant une inductance (61) et une capacité (62) en série;
   - soit un résonateur parallèle ($6_p$) en série avec la résistance (63), ledit résonateur parallèle ($6_p$) comportant une inductance (61) et une capacité (62) en parallèle.

4. Modulateur selon l'une quelconque des revendications précédentes, **caractérisé en ce que** ledit dispositif de résonance ($6'_{s2}$, $6'_{p2}$) à variation de phase minimale est à avance de phase lorsque la fonction de la résistance (63) est prépondérante dans une bande de fréquence comportant la fréquence de résonance.

5. Modulateur selon la revendication 4, **caractérisé en ce que** le dispositif de résonance ($6'_{s2}$, $6'_{p2}$) à variation de phase minimale et à avance de phase comporte :

   - soit un résonateur série ($6_s$) en série avec la résistance (63), ledit résonateur série ($6_s$) comportant une inductance (61) et une capacité (62) en série;
   - soit un résonateur parallèle ($6_p$) en parallèle avec la résistance (63), ledit résonateur parallèle ($6_p$) comportant une inductance (61) et une capacité (62) en parallèle.

6. Modulateur selon l'une quelconque des revendications précédentes, **caractérisé en ce que** le dispositif de résonance ($6''_s$, $6''_p$) à variation de phase minimale a un schéma équivalent comportant :

   - une première branche avec un résonateur série ($6_s$), ledit résonateur série ($6_s$) comportant une inductance (61) et une capacité en série (62),
   - une deuxième branche en parallèle avec le résonateur série ($6_s$) de la première branche, la deuxième branche comportant une capacité (64) et
   - une résistance (63) soit en parallèle avec le résonateur série ($6_s$) de la première branche et la capacité (64)

de la deuxième branche, soit en série avec le dispositif formé par le résonateur série ($6_s$) et la capacité (64).

**7.** Modulateur selon l'une quelconque des revendications précédentes, **caractérisé en ce que** le filtre est d'ordre supérieur.

**8.** Modulateur selon la revendication 7, **caractérisé en ce que** les dispositifs de résonance à variation de phase minimale sont assemblés soit en cascade, soit en échelle, soit en pont équilibré.

**9.** Modulateur selon l'une quelconque des revendications précédentes **caractérisé en ce que** les éléments composant le filtre sont réalisés sur un substrat piézo-électrique ou à l'intérieur d'un boîtier céramique.

**10.** Modulateur selon l'une quelconque des revendications précédentes, **caractérisé en ce que** un ou plusieurs des résonateurs est :

- soit un résonateur céramique,
- soit un résonateur à ondes acoustiques de surface,
- soit un résonateur à ondes acoustiques de volume, ou ses variantes FBAR,
- soit un résonateur diélectrique,
- soit un résonateur réalisé en supraconducteur, soit un résonateur de type GmC.

**11.** Modulateur selon l'une quelconque des revendications précédentes, **caractérisé en ce que** la boucle d'asservissement comporte un convertisseur analogique numérique sur la voie directe de la boucle et un convertisseur numérique analogique sur la voie retour de la boucle.

**12.** Modulateur selon l'une quelconque des revendications précédentes, **caractérisé en ce que :**

- soit un ou plusieurs des éléments composant le modulateur ΣΔ, soit tous les éléments composant le modulateur ΣΔ sont intégrés sur un semi-conducteur,
- et **en ce que** le filtre (11) est réalisé soit sur un substrat piézo-électrique rapporté sur le semi-conducteur, soit à l'intérieur d'un boîtier céramique.

## Claims

**1.** Bandpass sigma delta (ΣΔ) modulator forming a feedback loop comprising a filter carrying out the bandpass integration of a signal presented on its input, this operation being performed in continuous time, **characterized in that** said filter comprises a resonance device ($6'_{s1}$, $6'_{s2}$, $6'_{p1}$, $6'_{p2}$, $6''_s$ and $6''_p$) with minimum phase variation, said resonance device comprising a resonator (61-62, 64) and a resistor (63) whose function becomes preponderant over that of the resonator ($6_s$, $6_p$ and/or 64) in one or more determined frequency bands.

**2.** Modulator according to Claim 1, **characterized in that** the resonance device ($6'_{s1}$, $6'_{p1}$) with minimum phase variation exhibits a phase delay when the function of the resistor is preponderant in frequency bands which are symmetric with respect to the resonant frequency and exclude the resonant frequency.

**3.** Modulator according to Claim 2, **characterized in that** the resonance device ($6'_{s1}$, $6'_{p1}$) with minimum phase variation and with phase delay comprises:

- either a series resonator ($6_s$) in parallel with the resistor (63), said series resonator ($6_s$) comprising an inductor (61) and a capacitor (62) in series;
- or a parallel resonator ($6_p$) in series with the resistor (63), said parallel resonator ($6_p$) comprising an inductor (61) and a capacitor (62) in parallel.

**4.** Modulator according to any one of the preceding claims, **characterized in that** said resonance device ($6'_{s2}$, $6'_{p2}$) with minimum phase variation exhibits a phase lead when the function of the resistor (63) is preponderant in a frequency band comprising the resonant frequency.

**5.** Modulator according to Claim 4, **characterized in that** the resonance device ($6'_{s2}$, $6'_{p2}$) with minimum phase variation and phase lead comprises:

- either a series resonator ($6_s$) in series with the resistor (63), said series resonator ($6_s$) comprising an inductor (61) and a capacitor (62) in series;
- or a parallel resonator ($6_p$) in parallel with the resistor (63), said parallel resonator ($6_p$) comprising an inductor (61) and a capacitor (62) in parallel.

**6.** Modulator according to any one of the preceding claims, **characterized in that** the resonance device ($6''_s$, $6''_p$) with minimum phase variation has an equivalent diagram comprising:

- a first branch with a series resonator ($6_s$), said series resonator ($6_s$) comprising an inductor (61) and a capacitor in series (62),
- a second branch in parallel with the series resonator ($6_s$) of the first branch, the second branch comprising a capacitor (64) and
- a resistor (63) either in parallel with the series resonator ($6_s$) of the first branch and the capacitor (64) of the second branch, or in series with the device formed by the series resonator ($6_s$) and the capacitor (64).

**7.** Modulator according to any one of the preceding claims, **characterized in that** the filter is of higher order.

**8.** Modulator according to Claim 7, **characterized in that** the resonance devices with minimum phase variation are assembled either in cascade, or in a ladder layout, or in a balanced-bridge layout.

**9.** Modulator according to any one of the preceding claims, **characterized in that** the component elements of the filter are made on a piezo-electric substrate or inside a ceramic package.

**10.** Modulator according to any one of the preceding claims, **characterized in that** one or more of the resonators is:

- either a ceramic resonator,
- or a surface acoustic wave resonator,
- or a bulk acoustic wave resonator, or its FBAR variants,
- or a dielectric resonator,
- or a resonator made from a superconductor, or a resonator of GmC type.

**11.** Modulator according to any one of the preceding claims, **characterized in that** the feedback loop comprises an analogue digital converter on the direct pathway of the loop and a digital analogue converter on the return pathway of the loop.

**12.** Modulator according to any one of the preceding claims, **characterized in that:**

- either one or more of the component elements of the ΣΔ modulator, or all the component elements of the ΣΔ modulator are integrated on a semiconductor,
- and **in that** the filter (11) is made either on a piezo-electric substrate appended to the semiconductor, or inside a ceramic package.

## Patentansprüche

**1.** Bandpass-Sigma-Delta-Modulator (ΣΔ), der eine Regelschleife bildet, die ein Filter aufweist, das die Bandpass-Integration eines an seinem Eingang vorhandenen Signals durchführt, wobei dieser Vorgang zeitkontinuierlich durchgeführt wird, **dadurch gekennzeichnet, dass** das Filter eine Resonanzvorrichtung ($6'_{s1}$, $6'_{s2}$, $6'_{p1}$, $6'_{p2}$, $6''_s$ und $6''_p$) mit minimaler Phasenänderung aufweist, wobei die Resonanzvorrichtung einen Resonator (61-62, 64) und einen Widerstand (63) aufweist, dessen Funktion bezüglich derjenigen des Resonators ($6_s$, $6_p$ und/oder 64) in einem oder mehreren bestimmten Frequenzbändern präponderant wird.

**2.** Modulator nach Anspruch 1, **dadurch gekennzeichnet, dass** die Resonanzvorrichtung ($6'_{s1}$, $6'_{p1}$) mit minimaler Phasenänderung eine Phasenverzögerung hat, wenn die Funktion des Widerstands in bezüglich der Resonanzfrequenz symmetrischen und die Resonanzfrequenz ausschließenden Frequenzbändern präponderant ist.

**3.** Modulator nach Anspruch 2, **dadurch gekennzeichnet, dass** die Resonanzvorrichtung ($6'_{s1}$, $6'_{p1}$) mit minimaler Phasenänderung und mit Phasenverzögerung aufweist:

- entweder einen mit dem Widerstand (63) parallel geschalteten Reihenresonator ($6_s$), wobei der Reihenresonator ($6_s$) eine Drosselspule (61) und einen Kondensator (62) in Reihe geschaltet aufweist;
- oder einen mit dem Widerstand (63) in Reihe geschalteten Parallelresonator ($6_p$), wobei der Parallelresonator ($6_p$) eine Drosselspule (61) und einen Kondensator (62) parallel geschaltet aufweist.

**4.** Modulator nach einem der vorhergehenden Ansprüche, **dadurch gekennzeichnet, dass** die Resonanzvorrichtung ($6'_{s2}$, $6'_{p2}$) mit minimaler Phasenänderung mit Phasenvoreilung ist, wenn die Funktion des Widerstands (63) in einem die Resonanzfrequenz enthaltenden Frequenzband präponderant ist.

**5.** Modulator nach Anspruch 4, **dadurch gekennzeichnet, dass** die Resonanzvorrichtung ($6'_{s2}$, $6'_{p2}$) mit minimaler Phasenänderung und mit Phasenvoreilung aufweist:

- entweder einen mit dem Widerstand (63) in Reihe geschalteten Reihenresonator ($6_s$), wobei der Reihenresonator ($6_s$) eine Drosselspule (61) und einen Kondensator (62) in Reihe geschaltet aufweist;
- oder einen mit dem Widerstand (63) parallel geschalteten Parallelresonator ($6_p$), wobei der Parallelresonator ($6_p$) eine Drosselspule (61) und einen Kondensator (62) parallel geschaltet aufweist.

**6.** Modulator nach einem der vorhergehenden Ansprüche, **dadurch gekennzeichnet, dass** die Resonanzvorrichtung ($6''_s$, $6''_p$) mit minimaler Phasenänderung ein Ersatzschaltbild hat, das aufweist:

- einen ersten Zweig mit einem Reihenresonator ($6_s$), wobei der Reihenresonator ($6_s$) eine Drosselspule (61) und einen Kondensator (62) in Reihe geschaltet aufweist,
- einen mit dem Reihenresonator ($6_s$) des ersten Zweigs parallel geschalteten zweiten Zweig, wobei der zweite Zweig einen Kondensator (64) aufweist, und
- einen Widerstand (63), entweder mit dem Reihenresonator ($6_s$) des ersten Zweigs und dem Kondensator (64) des zweiten Zweigs parallel geschaltet, oder mit der von dem Reihenresonator ($6_s$) und dem Kondensator (64) gebildeten Vorrichtung in Reihe geschaltet.

**7.** Modulator nach einem der vorhergehenden Ansprüche, **dadurch gekennzeichnet, dass** das Filter von höherer Ordnung ist.

**8.** Modulator nach Anspruch 7, **dadurch gekennzeichnet, dass** die Resonanzvorrichtungen mit minimaler Phasenänderung entweder in Kaskadenschaltung oder in Treppenschaltung oder in Ausgleichsbrückenschaltung zusammengebaut sind.

**9.** Modulator nach einem der vorhergehenden Ansprüche, **dadurch gekennzeichnet, dass** die das Filter bildenden Elemente auf einem piezoelektrischen Substrat oder im Inneren eines Keramikgehäuses gestaltet sind.

**10.** Modulator nach einem der vorhergehenden Ansprüche, **dadurch gekennzeichnet, dass** einer oder mehrere der Resonatoren:

- entweder ein Keramikresonator,
- oder ein Resonator mit akustischen Oberflächenwellen,
- oder ein Resonator mit akustischen Volumenwellen, oder seine FBAR-Varianten,
- oder ein dielektrischer Resonator,
- oder ein als Supraleiter gestalteter Resonator, oder ein Resonator vom Typ GmC ist.

**11.** Modulator nach einem der vorhergehenden Ansprüche, **dadurch gekennzeichnet, dass** die Regelschleife einen Analog/Digital-Wandler auf dem direkten Weg der Schleife und einen Digital/Analog-Wandler auf dem Rückweg der Schleife aufweist.

**12.** Modulator nach einem der vorhergehenden Ansprüche, **dadurch gekennzeichnet, dass:**

- entweder eines oder mehrere der den Modulator ΣΔ bildenden Elemente oder alle den Modulator ΣΔ bildenden Elemente auf einem Halbleiter integriert sind,
- und dass das Filter (11) entweder auf einem auf den Halbleiter aufgesetzten piezoelektrischen Substrat oder im Inneren eines Keramikgehäuses gestaltet ist.

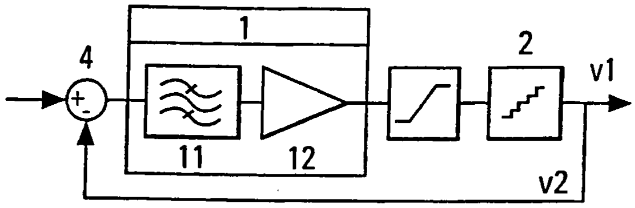


Fig. 1a

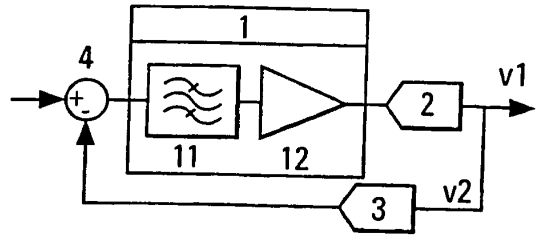


Fig. 1b

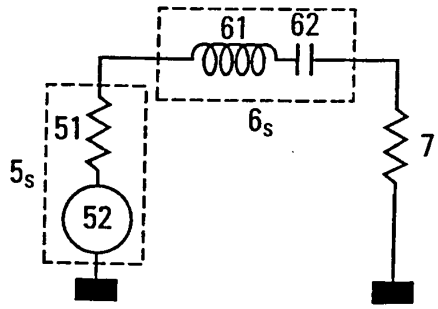


Fig. 2a

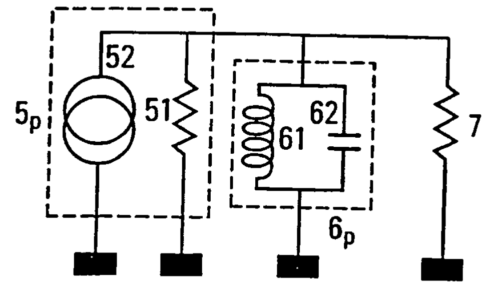


Fig. 2b

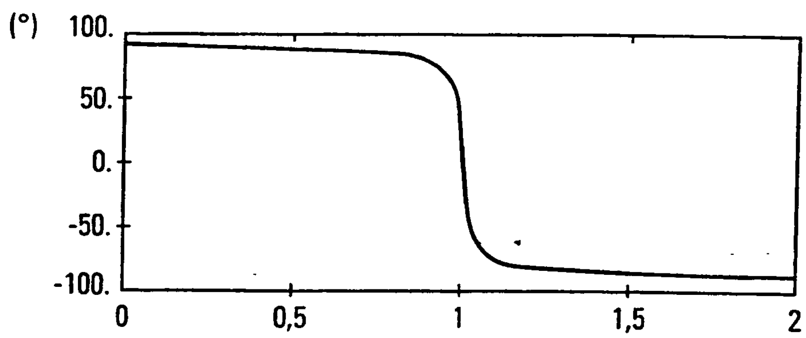


Fig. 3a

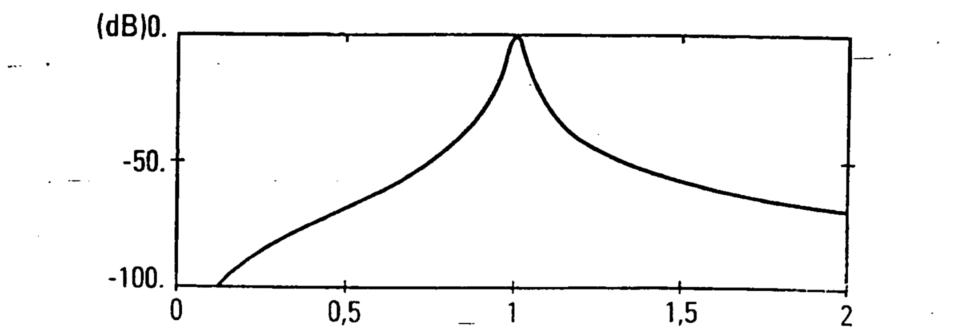

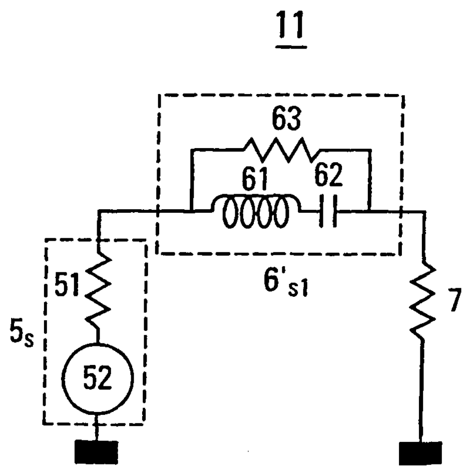


Fig. 4a

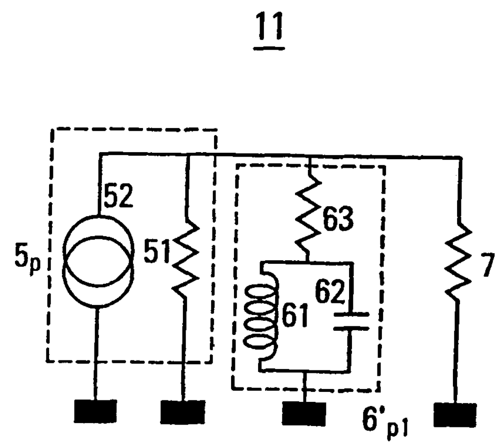


Fig. 4b

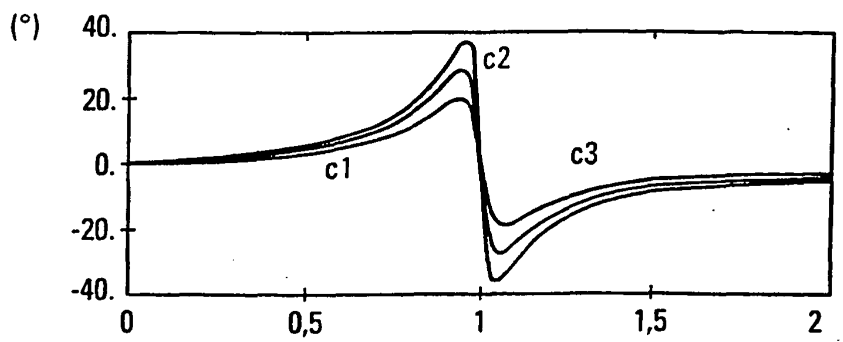


Fig. 5a

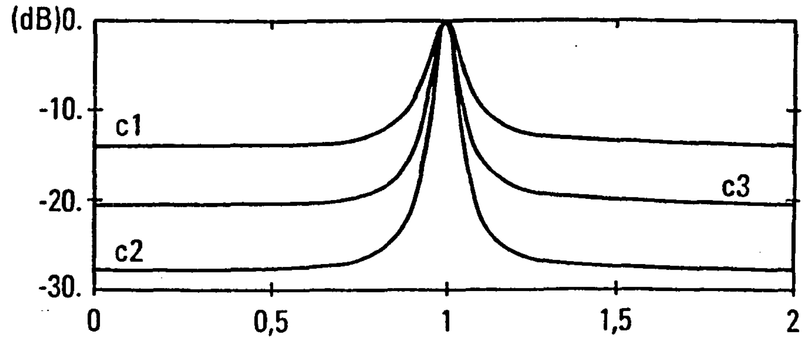


Fig. 5b

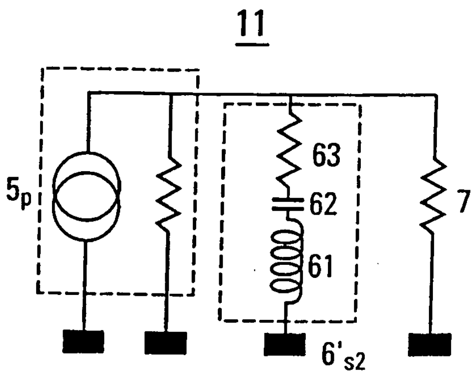


Fig. 6a

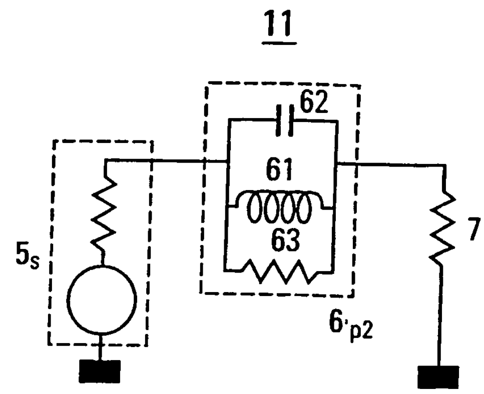


Fig. 6b

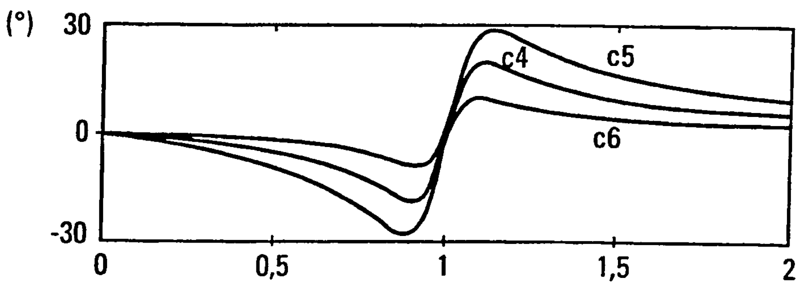


Fig. 7a

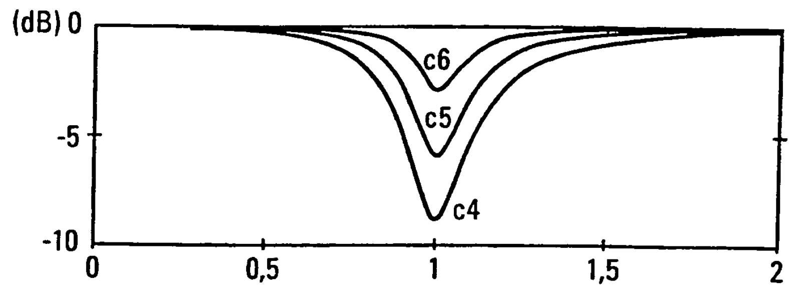


Fig. 7b

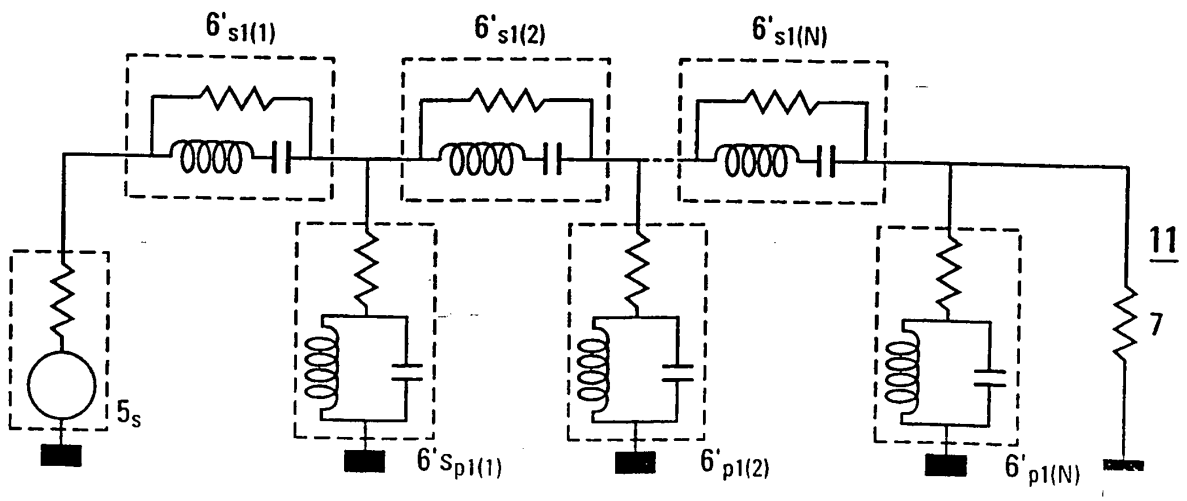

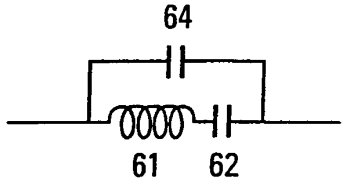


Fig. 9

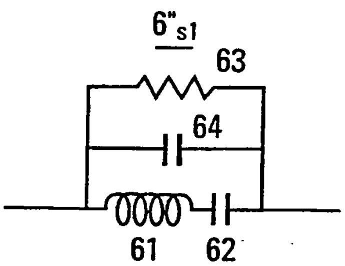


Fig. 10(a)

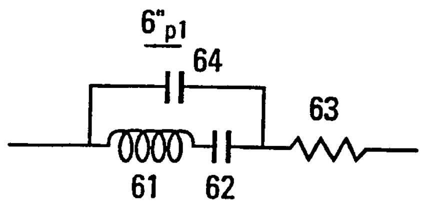


Fig. 10(b)

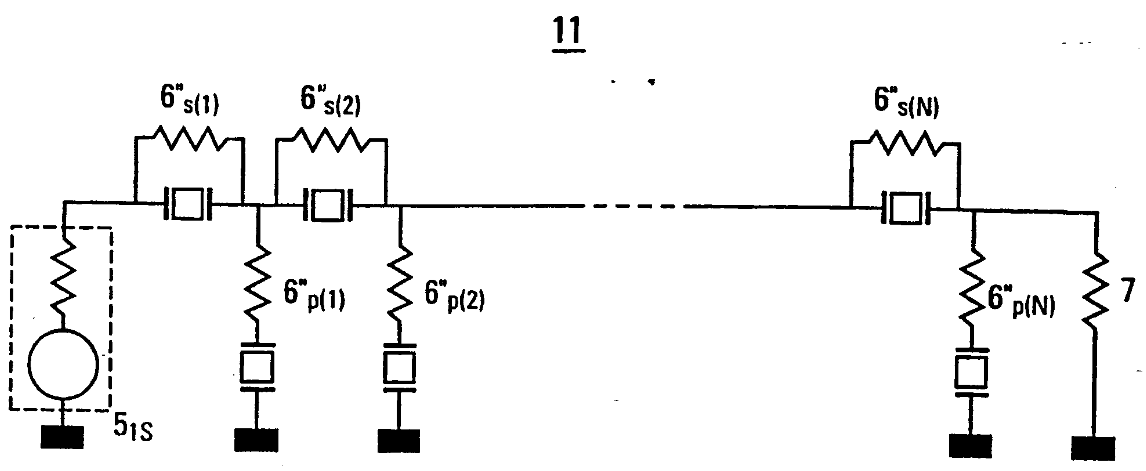


Fig. 11

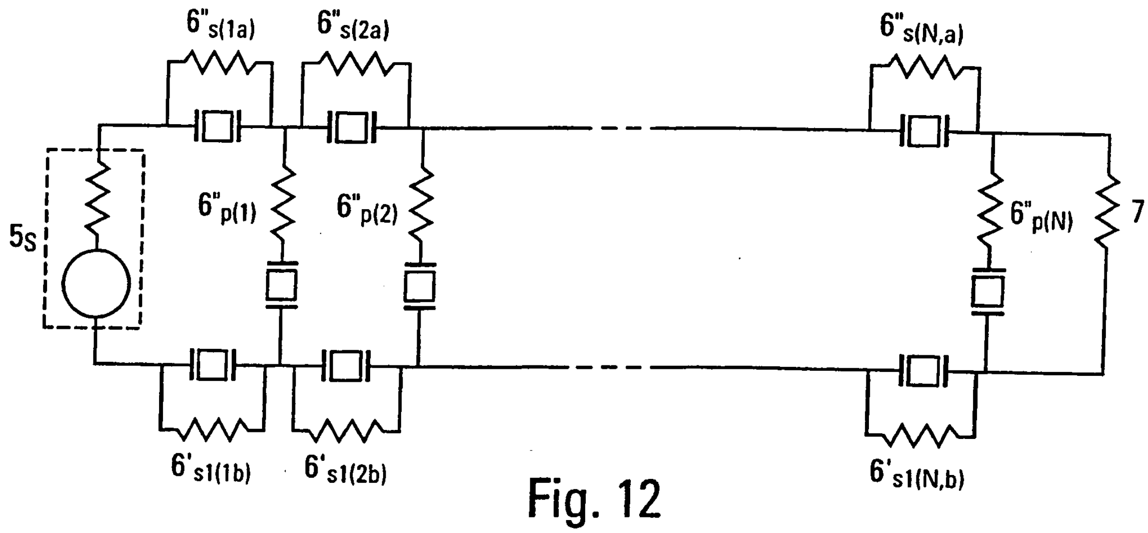


Fig. 12

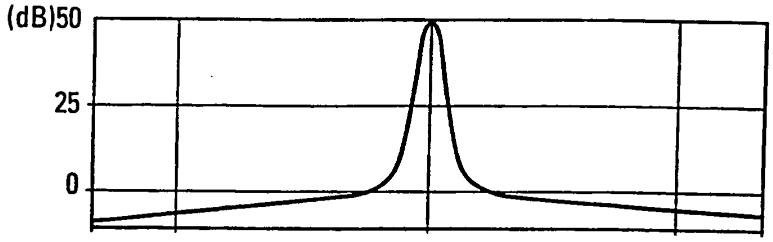


Fig. 13(b)

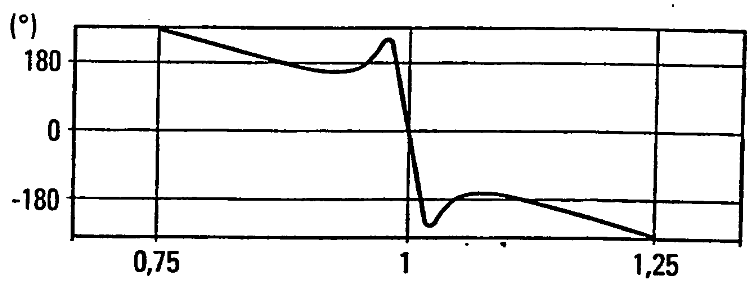


Fig. 13(a)

1

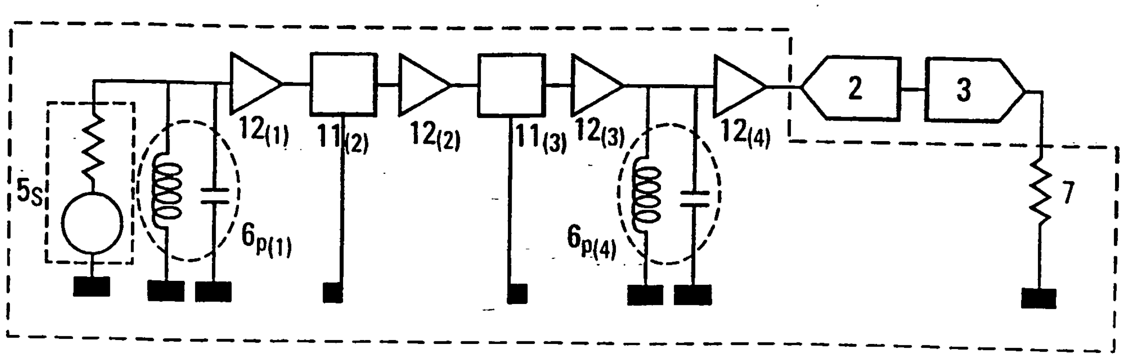


Fig. 14

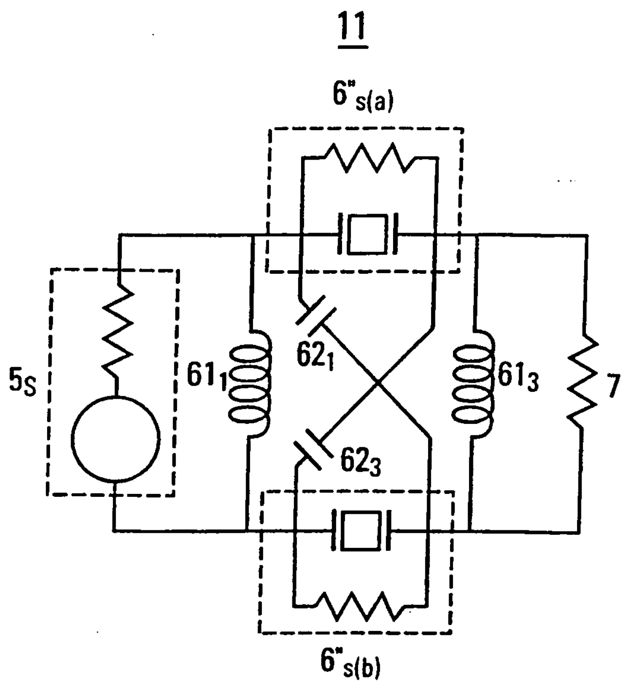


Fig. 15

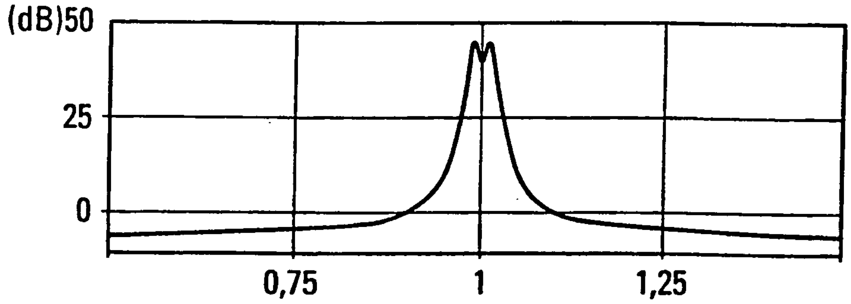


Fig. 16(b)

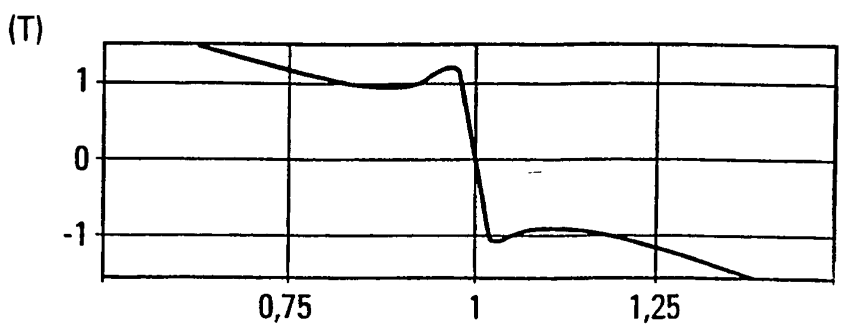


Fig. 16(a)

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- DE 3504383
- US 4467291 A